# EUROPEAN PATENT APPLICATION

(11) **EP 2 037 012 A1**
(43) Date of publication of application: **18.03.2009**
(21) Application number: 07745331.4
(22) Date of filing: 15.06.2007
(51) Int. Cl.: C30B 29/38, H01L 21/20, H01L 21/203, H01L 33/00

(54) **PROCESS FOR PRODUCING SUBSTRATE OF AlN CRYSTAL, METHOD OF GROWING AlN CRYSTAL, AND SUBSTRATE OF AlN CRYSTAL**

(30) Priority: 04.07.2006 JP 2006184453
(71) Applicant: Sumitomo Electric Industries, Ltd., Chuo-ku Osaka-shi Osaka 540-0041 (JP)
(72) Inventor: MIZUHARA, Naho, Itami-shi Hyogo 664-0016 (JP); KAWASE, Tomohiro, Itami-shi Hyogo 664-0016 (JP); MIYANAGA, Michimasa, Itami-shi Hyogo 664-0016 (JP)
(74) Representative: Grünecker, Kinkeldey, Stockmair & Schwanhäusser Anwaltssozietät
(86) International application number: PCT/JP2007/062076
(87) International publication number: WO 2008/004424

(57) **Abstract**

Affords AlN crystal substrate manufacturing methods whereby large-scale, high-quality AlN crystal substrates can be manufactured; AlN crystal growth methods whereby bulk AlN of superior crystallinity can be grown; and AlN crystal substrates composed of the AlN crystal grown by the growth methods.

AlN crystal substrate manufacturing method including: a step of growing an AlN crystal by sublimation onto a heterogeneous substrate to a thickness of, with respect to the heterogeneous-substrate diameter *r*, 0.4*r* or more; and a step of forming an AlN crystal substrate from region of the AlN crystal not less than 200 µm away from the heterogeneous substrate. Also, AlN crystal growth technique of growing an AlN crystal by sublimation onto an AlN crystal substrate manufactured by the manufacturing method, and AlN crystal substrates composed of the AlN crystal grown by the growth technique.

## Description

### Technical Field

The present invention relates to methods of manufacturing AlN crystal (aluminum nitride crystal) substrates, to methods of growing AlN crystals, and to AlN crystal substrates composed of the AlN crystals grown by the growth methods.

### Background Art

AlN crystals have gained attention as substrate materials for optoelectronic and other semiconductor devices on account of the crystal's having an energy bandgap of 6.2 eV, a thermal conductivity of approximately 3.3 WK⁻¹ cm⁻¹, and high electrical resistance.

Known approaches to growing such AlN crystals include, for example, techniques in which the crystal is grown by sublimation onto a heterogeneous substrate, such as a SiC (silicon carbide) substrate, and non seeded growth by sublimation. (Cf., for example, Non-Patent Reference 1).
Non-Patent Reference 1: B. Raghothamachar et al., X-ray characterization of bulk AlN single crystals grown by the sublimation technique, Journal of Crystal Growth, 250 (2003), pp. 244-250.

### DISCLOSURE OF INVENTION

### Problems Invention is to Solve

With the techniques of growing AlN crystal onto a heterogeneous substrate by sublimation, employing large-diameter heterogeneous substrates enables growing bulk AlN crystal. A problem with this approach, however, has been that cracking and dislocation density stemming from disparity in lattice constant, disparity in thermal expansion coefficient, and other differences between the heterogeneous substrate and the AlN crystal increase, compromising the AlN crystal quality and in turn compromising the quality of the AlN crystal substrates obtained from the AlN crystal.

Likewise, a problem with AlN crystal produced by the non seeded growth of AlN crystal by sublimation is that AlN crystal of size sufficient to allow its application as substrates for optoelectronic and other semiconductor devices has been unobtainable.

Accordingly, an object of the present invention is to make available AlN crystal substrate manufacturing methods whereby large-scale, high-quality AlN crystal substrates can be manufactured; AlN crystal growth methods whereby bulk AlN of superior crystallinity can be grown; and AlN crystal substrates composed of the AlN crystal grown by the growth methods.

### Means for Resolving the Problems

The present invention is an AlN crystal substrate manufacturing method including: a step of growing an AlN crystal by sublimation onto a heterogeneous substrate to a thickness of, with respect to the heterogeneous-substrate diameter *r*, 0.4*r* or more; and a step of forming an AlN crystal substrate from a region of the AlN crystal not less than 200 µm away from the heterogeneous substrate.

Herein, in an AlN crystal substrate manufacturing method of the present invention, it is preferable that the AlN crystal dislocation density decreases monotonically with increasing distance from the heterogeneous substrate in the direction in which the AlN crystal grows.

Furthermore, in an AlN crystal substrate manufacturing method of the present invention, it is preferable that, letting distance from the heterogeneous substrate in the AlN crystal growth direction be t (mm) and dislocation density of the AlN crystal when t = 1 be a (/cm²), the AlN crystal dislocation density *E* lies in a region between the function expressed by the formula E= *a* × *t*^{-0.1} and the function expressed by the formula E= *a* × *t*⁻³, for t ≥ 1.

The present invention is also an AlN crystal growth method of growing AlN crystal by sublimation onto an AlN crystal substrate manufactured by any of the above-described AlN crystal substrate manufacturing methods.

Herein, in an AlN crystal growth method of the present invention, the AlN crystal substrate preferably has a diameter of 2 inches or more.

Furthermore, in an AlN crystal growth method of the present invention, the temperature of the raw material when the AlN crystal is grown onto the AlN crystal substrate is preferably higher than the temperature of the raw material when AlN crystal is grown onto the heterogeneous substrate.

The present invention further is an AlN crystal substrate composed of AlN crystal grown by any of the above-described AlN crystal growth methods.

### Effects of the Invention

The present invention affords AlN crystal substrate manufacturing methods whereby large-scale, high-quality AlN crystal substrates can be manufactured; AlN crystal growth methods whereby bulk AlN of superior crystallinity can be grown; and AlN crystal substrates composed of the AlN crystal grown by the growth methods.

### Brief Description of Drawings

Fig. 1A is a schematic sectional diagram representing one preferable example of an AlN crystal substrate manufacturing method of the present invention.
Fig. 1B is a schematic sectional diagram representing the one preferable example of the AlN crystal substrate manufacturing method of the present invention.
Fig. 1C is a schematic sectional diagram representing the one preferable example of the AlN crystal substrate manufacturing method of the present invention.
Fig. 1D is a schematic sectional diagram representing the one preferable example of the AlN crystal substrate manufacturing method of the present invention.
Fig. 2 is a graph plotting one example of a profile of dislocation density in AlN crystal grown, in the present invention, onto a heterogeneous substrate.
Fig. 3A is a schematic sectional diagram for illustrating one preferable example of an AlN crystal growth method of the present invention.
Fig. 3B is a schematic sectional diagram for illustrating the one preferable example of the AlN crystal growth method of the present invention.
Fig. 3C is a schematic sectional diagram for illustrating the one preferable example of the AlN crystal growth method of the present invention.
Fig. 4 is a schematic sectional view of a crystal-growth furnace employed in Embodiments 1 through 3 and Comparative Example 1.

### Legend

1: heterogeneous substrate
2, 4: AlN crystal
3, 5: AlN crystal substrates
6, 7, 8, 9: dashed lines
10, 11: regions
12, 13: mathematical functions
15: crucible
16: SiC substrate
17: AlN powder
18: seed-crystal protector
19: heat insulator
21*a*, 21*b*: radiation thermometer
22: reaction chamber
23: high-frequency heating coil

### Best Mode for Carrying Out the Invention

Below, a description of modes of embodying the present invention will be made. It should be understood that in the drawings for the present invention, identical reference marks indicate identical or corresponding parts.

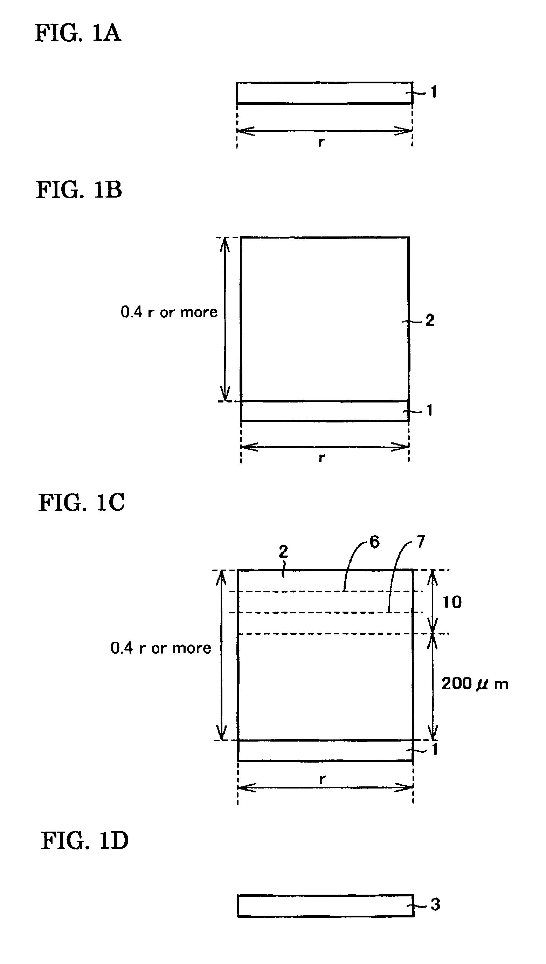

Schematic sectional diagrams in Figs. 1A through 1D represent one preferable example of an AlN crystal substrate manufacturing method of the present invention. First, as illustrated in Fig. 1A, a heterogeneous substrate 1 whose diameter is ris prepared. Herein, in the present invention, materials for the heterogeneous substrate 1 are not particularly limited as long as they are different from AlN, but from the perspectives of making it possible to enlarge the diameter r of the heterogeneous substrate 1, of having a high melting point, and of being fairly close to AlN crystal in lattice constant and thermal expansion coefficient, SiC is preferably employed.

Next, as illustrated in Fig. 1B, an AlN crystal 2 is grown onto the heterogeneous substrate 1 by sublimation to a thickness of 0.4*r* or more. Here, "sublimation" is a technique of producing solid crystal by the sublimation and subsequent recondensation of a solid raw material.

Subsequently, as illustrated in Fig. 1C, in a region 10 of the AlN crystal 2 where it is not less than 200 µm away from the heterogeneous substrate 1, a section-for example, between the two dashed lines 6 and 7-is sliced out. An AlN crystal substrate 3 illustrated in Fig. 1D is thereby formed from the sliced-out section.

By enlarging the diameter of the heterogeneous substrate 1, the AlN crystal substrate 3 obtained in this manner can be scaled-up large in diameter, and furthermore can be made high-quality and low-dislocation-density This is something that present inventors discovered as a result of concentrated investigative effort, but the reason it allows the quality of the AlN crystal substrate 3 to be enhanced is not clear.

Herein, in an AlN crystal substrate manufacturing method of the present invention, it is preferable that with increasing distance from the heterogeneous substrate 1 in the direction in which the AlN crystal 2 grows, the dislocation density in the AlN crystal 2 decreases monotonically (that is, it is preferable that the dislocation density in the AlN crystal 2 decreases monotonically from the heterogeneous substrate 1 to the utmost surface of the AlN crystal 2). In this case, the dislocation density of the AlN crystal substrate 3 drops further, and the AlN crystal substrate 3 tends to be of higher quality.

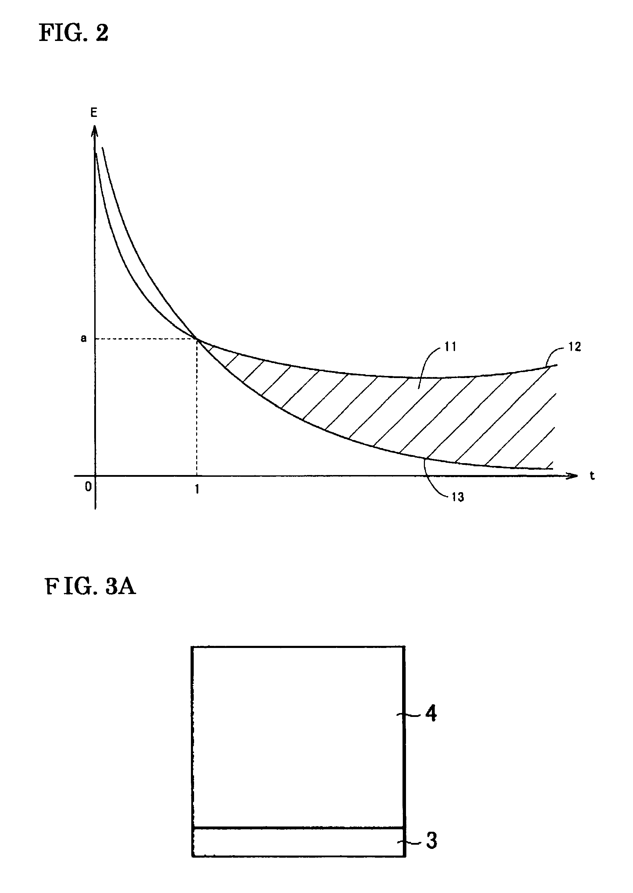

Furthermore, in a case in which, letting the distance from the heterogeneous substrate 1 in the direction in which the AlN crystal 2 grows be t (mm), the dislocation density in the AlN crystal 2 monotonically decreases with increasing t, then, letting the dislocation density when *t=* 1 be a (/cm²), for *t* ≥ 1 (the portion of the AlN crystal 2 that is at a distance of 1 mm or more from the heterogeneous substrate 1 in the direction in which the AlN crystal 2 grows), the dislocation density E of the AlN crystal 2 preferably lies in a region between the function expressed by E= *a* × *t*^{-0.1} and the function expressed by E= *a* × *t*⁻³. That is, as shown in Fig. 2, for example, the AlN crystal 2 dislocation density E preferably lies in a region 11 (the diagonally hatched region in Fig. 2) between the function 12 expressed by the formula of E = *a* × *t*^{*-*0.1} and the function 13 expressed by the formula of *E*= *a* × *t*^{*-*3}. If the AlN crystal 2 dislocation density *E* lies in the region above and beyond the region 11, the decrease in the dislocation density of the AlN crystal 2 abates, or else the AlN crystal 2 dislocation density instead increases, such that the crystallinity of the AlN crystal 2 is liable to turn out poor. On the other hand, if the AlN crystal 2 dislocation density *E* lies in the region below and beyond the region 11, due to the abrupt decrease in dislocation density in the AlN crystal 2, warpage in the AlN crystal 2 and AlN crystal substrates produced from the AlN crystal 2 is liable to be serious. When the AlN crystal 2 dislocation density *E* lies in the region 11, the AlN crystal 2 is predisposed to have the crystallinity allowing it to serve as a substrate for devices including optoelectronic and other semiconductor devices. It should be understood that in Fig. 2, the horizontal axis represents the distance *t* (mm) from the heterogeneous substrate 1 in the AlN crystal 2 growth direction, and the vertical axis represents the AlN crystal 2 dislocation density *E* (/cm²).

To continue, one preferable example of an AlN crystal growth method of the present invention is illustrated by the schematic sectional diagrams of Figs. 3A through 3C. Herein, as illustrated in Fig. 3A, initially an AlN crystal 4 is grown by sublimation onto an AlN crystal substrate 3 produced in the above manner.

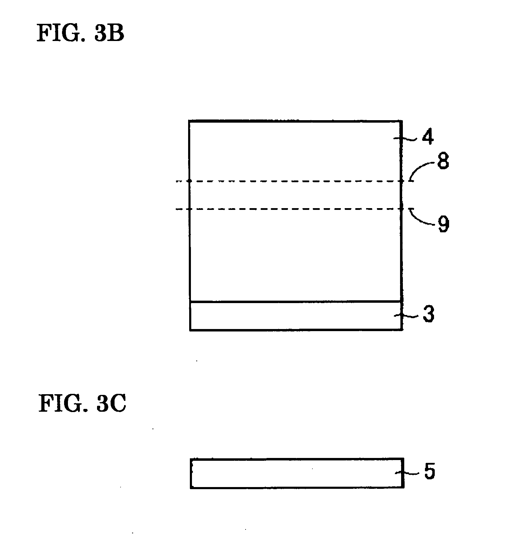

Next, as illustrated in Fig. 3B, by slicing out the section, between the two dashed lines 8 and 9, of the AlN crystal 4 grown onto the AlN crystal substrate 3, an AlN crystal substrate 5 illustrated in Fig. 3C can be manufactured.

Because the AlN crystal substrate 5 manufactured in this manner is a substrate sliced out from the AlN crystal 4 grown onto the high-quality AlN crystal substrate 3 of large size and of low dislocation density, the diameter of the AlN crystal substrate 5 is scaled-up large, and the substrate is of still lower dislocation density and higher quality than the AlN crystal substrate 3.

Furthermore, in an AlN crystal growth method of the present invention, from the perspective of growing a bulk AlN crystal 4, the AlN crystal substrate 3 preferably has a diameter of 2 inches or more.

Moreover, in an AlN crystal growth method of the present invention, the growth temperature (raw-material temperature) at which an AlN crystal 4 is grown onto the AlN crystal substrate 3 illustrated in Fig. 3 is preferably higher than the growth temperature (raw-material temperature) at which an AlN crystal 2 is grown onto the heterogeneous substrate 1 illustrated in Fig. 1. The AlN crystal substrate 3 composed of AlN crystal has a high melting point, which enables growing the AlN crystal 4 at high temperatures. Therefore, the growth rate of the AlN crystal 4 can be heightened. Accordingly, these implementations are predisposed to enabling further improvement in productivity of the AlN crystal 4.

These AlN crystal substrates manufactured by the AlN crystal substrate manufacturing methods of the present invention, and AlN crystal substrates composed of the AlN crystals formed by the AlN crystal growth methods of the present invention can be made of large size and of high quality. Therefore, they are employed ideally in devices including, for example: optoelectronic devices (such as light-emitting diodes and laser diodes); solid-state devices (such as rectifiers, bipolar transistors, field-effect transistors, and HEMTs); semiconductor sensors (such as temperature, pressure, and radiation sensors, and visible-blind ultraviolet detectors); surface acoustic wave (SAW) devices; acceleration sensors; micro-electromechanical system (MEMS) parts; piezoelectric vibrators; resonators; and piezoelectric actuators.

### Embodiments

### Embodiment 1

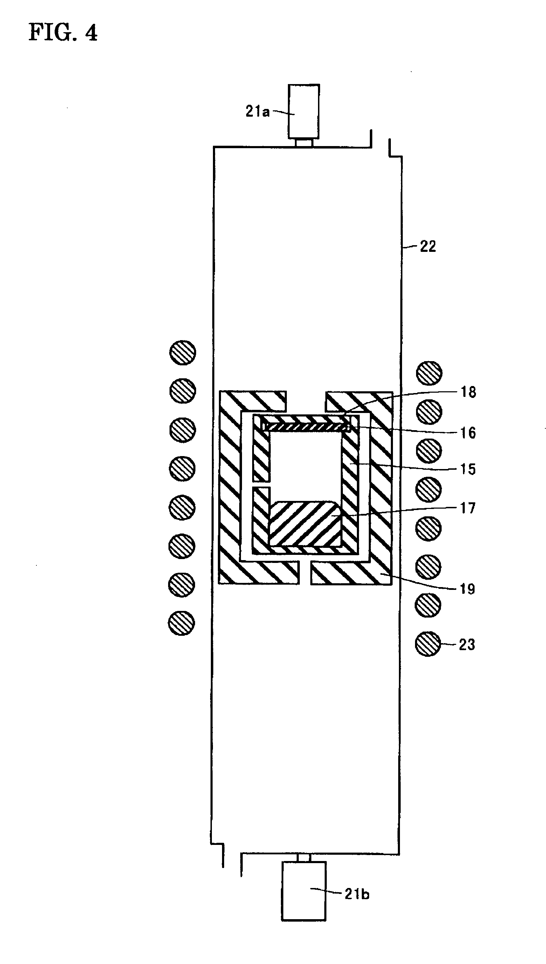

First, a SiC substrate 16 in the form of a disk was arranged as a heterogeneous substrate in the top part of a crucible 15 in the crystal growth furnace represented in Fig. 4, and AlN powder 17 that was a raw material was accommodated in the lower part of the crucible 15. Herein, the SiC substrate 16 had diameter r of 2 inches (50.8 mm) and thickness of 0.5 mm. Furthermore, a seed-crystal protector 18 was arranged so as to closely contact the back side of the SiC substrate 16 to prevent with the seed-crystal protector 18 the SiC substrate 16 from sublimating. It should be understood that the crystal growth furnace illustrated in Fig. 4 includes a heat insulator 19 and radiation thermometers 21*a* and 21*b.*

Next, nitrogen gas was flowed into the reaction chamber 22, and meanwhile the temperature inside the crucible 15 was raised with a high-frequency heating coil 23 to bring temperature of the SiC substrate 16 to 1700°C, and to bring temperature of the AlN powder 17 to 1900°C, whereby the AlN powder 17 was sublimated and recondensed onto the SiC substrate 16 to heteroepitaxially grow, by sublimation, AlN crystal onto the SiC substrate 16 to a thickness of 0.4*r* (20.32 mm) or more.

It should be understood that during the AlN crystal heteroepitaxial growth, the nitrogen gas was continuously flowed into the reaction chamber 22, and volume of the emitted nitrogen gas was controlled so that the gas partial pressure in the reaction chamber 22 was brought to some 10 kPa to 100 kPa. Furthermore, after the AlN crystal heteroepitaxial growth, the AlN crystal was cooled down to room temperature (25°C).

Herein, as a result of heteroepitaxially growing separately an AlN crystal onto a SiC substrate in the same manner as, and under the same conditions as, in the present embodiment to examine dislocation densities in the AlN crystal in the thickness direction, dislocation density in the AlN crystal when the distance t (mm) from the SiC substrate 16 in the AlN crystal growing direction was 1 mm was 5.0 × 10⁶ (/cm²).

It should be understood that the dislocation density of the AlN crystal was determined by slicing the AlN crystal in a direction parallel to the SiC substrate surface at a plurality of points differing from each other along the AlN crystal thickness to expose AlN crystal surfaces, and by subjecting each of the exposed surfaces to surface etching for 30 minutes with molten KOH-NaOH mixture (KOH mass : NaOH mass = 1 : 1) at 250°C to measure densities of etch pits appearing on the surfaces. Then, a graph was plotted with the above determined dislocation densities in the AlN crystal being on the vertical axis, and with the distances, from the SiC substrate, at which they were measured being on the horizontal axis.

Subsequently, the AlN crystal heteroepitaxially grown onto the SiC substrate 16 was cut paralleling the surface of the SiC substrate 16 in respective locations at a distance 200 µm from the SiC substrate 16 and a distance 0.5 mm away from that location, in the direction opposite from that toward where the SiC substrate 16 lay. Then, the surface thereof was polished to a specular finish and etched, to fabricate an AlN crystal substrate (a first AlN crystal substrate A of Embodiment 1) in the form of a disk. Herein, the first AlN crystal substrate A of Embodiment 1 had diameter of 2 inches (50.8 mm) and thickness of 0.5 mm.

For the AlN crystal substrate A of Embodiment 1, the full-width at half maximum of an X-ray rocking curve for its (0002) face, and the dislocation density were characterized. The results are set forth in Table I. As shown in Table I, in the first AlN crystal substrate A of Embodiment 1, the full-width at half maximum of the X-ray rocking curve for its (0002) face was 350 arcsec, and the dislocation density was 5.2 × 10⁶ /cm².

Here, the full-width at half maximum of the X-ray rocking curve for the (0002) face of the first AlN crystal substrate A of Embodiment 1 was measured with an X-ray diffractometer. Furthermore, the dislocation density in the first AlN crystal substrate A of Embodiment 1 was determined by subjecting the entire surface of the first AlN crystal substrate A of Embodiment 1 to etching for 30 minutes with a molten KOH-NaOH mixture (KOH mass : NaOH mass = 1 : 1) at 250°C, and counting 100 etch pits on the surface of the first AlN crystal substrate A of Embodiment 1, calculating the area of the region in which the etch pits were counted, and dividing the 100 etch pits by the area.

In addition to the above first AlN crystal substrate A of Embodiment 1, the AlN crystal was cut parallel to the surface of the SiC substrate 16 in each of locations at distances 200 µm + 2 mm, 200 µm + 4 mm, 200 µm + 10 mm, and 200 µm + 20 mm from the SiC substrate 16, and in locations at a distance of 0.5 mm from each of these locations in the direction opposite from that toward where the SiC substrate 16 lay, to fabricate a first AlN crystal substrate *B* (cutting point: 200 µm + 2 mm), a first AlN crystal substrate C (cutting point: 200 µm + 4 mm), a first AlN crystal substrate D (cutting point: 200 µm + 10 mm), and a first AlN crystal substrate E (cutting point: 200 µm + 20 mm) of Embodiment 1.

Also in these first AlN crystal substrates B to E of Embodiment 1, the full-width at half maximum of an X-ray rocking curve for their (0002) faces and the dislocation density were characterized in the same manner as, and under the same conditions as, in the above first AlN crystal substrate A of embodiment 1. The results are set forth in Table I.

As is clear from the results of evaluating the first AlN crystal substrates A to E of in Embodiment 1, shown in Table I, in the AlN crystal grown in Embodiment 1, the dislocation density of the AlN crystal decreases with increasing distance from the SiC substrate 16 in the AlN crystal growth direction, and, letting the distance from the SiC substrate 16 in the AlN crystal growing direction be t (mm) and the dislocation density in the AlN crystal when *t=* 1 be *a* (/cm²), then the dislocation density E of the AlN crystal lay in a region between the function expressed by the formula of *E = a* × *t*^{-0.1} and the function expressed by the formula of *E* = *a* × *t*⁻³ for *t* ≥ 1, and in this region, the dislocation density in the AlN crystal decreased with increasing distance in the growth direction.

Furthermore, as substitute for a SiC substrate 16, the above first AlN crystal substrate A of Embodiment 1 was arranged in the top part of a crucible 15 in a furnace as illustrated in Fig. 4, and AlN powder 17 that was a raw material was stored in the under part of the crucible 15. Also in this case, a seed-crystal protector 18 was arranged so as to closely contact with the back side of the first AlN crystal substrate A of Embodiment 1 to prevent with the seed-crystal protector 18 the first AlN crystal substrate A of Embodiment 1 from sublimating.

Subsequently, nitrogen gas was flowed into the reaction chamber 22, and meanwhile the temperature inside the crucible 15 was raised with the high-frequency heating coil 23 to bring temperature of the first AlN crystal substrate A of Embodiment 1 to 2000°C, and to bring temperature of the AlN powder 17 to 2300°C, whereby the AlN powder 17 was sublimated and recondensed onto the first AlN crystal substrate A of Embodiment 1 to homoepitaxially grow, by sublimation, AlN crystal onto the first AlN crystal substrate A of Embodiment 1.

Herein, also during the AlN crystal homoepitaxial growth, the nitrogen gas was continuously flowed into the reaction chamber 22, and the volume of the emitted nitrogen gas was controlled so that the gas partial pressure in the reaction chamber 22 was brought to some 10 kPa to 100 kPa. Furthermore, after the AlN crystal homoepitaxial growth, the AlN crystal was cooled down to room temperature (of 25°C).

The AlN crystal formed in the above manner was cut parallel to the surface of the first AlN crystal substrate A of Embodiment 1 in respective locations at a distance 200 µm from the first AlN crystal substrate A of Embodiment 1 and at a distance 0.5 mm from that location, in the direction opposite from that toward where the first AlN crystal substrate A of Embodiment 1 lay. Then the surface thereof was polished to a specular finish and etched, to produce an AlN crystal substrate (a second AlN crystal substrate *A* of Embodiment 1) having diameter of 2 inches and thickness of 0.5 mm in the form of a disk.

In the second AlN crystal substrate A of Embodiment 1, the full-width at half maximum of an X-ray rocking curve for its (0002) face and the dislocation density were evaluated in the same manner as, and under the same conditions as, in the first AlN crystal substrate A of Embodiment 1. The results are set forth in Table I. As shown in Table I, in the second AlN crystal substrate A of Embodiment 1, the full-width at half maximum of an X-ray rocking curve for its (0002) face was 200 arcsec, and the dislocation density was 2 × 10⁶/cm².

Furthermore, in the same manner as, and under the same conditions as, in the first AlN crystal substrate A of Embodiment 1, AlN crystals were each grown onto the above first AlN crystal substrates B to E of Embodiment 1 to fabricate second AlN crystal substrates *B* to *E* of Embodiment 1 respectively from the grown AlN crystals as in the second AlN crystal substrate A of Embodiment 1.

Subsequently, in the second AlN crystal substrates B to E of Embodiment 1, the full-width at half maximum of an X-ray rocking curve for their (0002) faces and the dislocation density were evaluated in the same manner as, and under the same conditions as, in the second AlN crystal substrate A of Embodiment 1. The results are set fort in Table I.

**Table I**

| 1^{st} AlN crystal substrate cutting position | Location 200 µm away from SiC substrate | Location 200 µm + 2 mm away from SiC substrate | Location 200 µm + 4 mm away from SiC substrate | Location 200 µm + 10 mm away from SiC substrate | Location 200 µm + 20 mm away from SiC substrate |
|---|---|---|---|---|---|
| FWHM of X-ray rocking curve for 1^{st} AlN crystal substrate (arcsec) | 350 | 380 | 100 | 51 | 32 |
| Disloc. dens. of 1^{st} AlN crystal substrate (/cm²) | 5.2 × 10⁶ | 3 × 10⁶ | 7 × 10⁵ | 3.4 × 10⁴ | 9.8 × 10³ |
| FWHM of X-ray rocking curve for 2^{nd} AlN crystal substrate (arcsec) | 200 | 145 | 80 | 45 | 31 |
| Disloc. dens. of 2^{nd} AlN crystal substrate (/cm²) | 2 × 10⁶ | 1.5 × 10⁵ | 6 × 10⁵ | 1 × 10⁴ | 9 × 10³ |
| Characterized substrates | 1^{st} AlN crystal substrate A 2^{nd} AlN crystal substrate *A* | 1^{st} AlN crystal substrate B 2^{nd} AlN crystal substrate B | 1^{st} AlN crystal substrate C 2^{nd} AlN crystal substrate C | 1^{st} AlN crystal substrate D 2^{nd} AlN crystal substrate D | 1^{st} AlN crystal substrate *E* 2^{nd} AlN crystal substrate E |

### Embodiment 2

First, in the same manner as in Embodiment 1, an AlN crystal was heteroepitaxially grown by sublimation onto a SiC substrate to a thickness of, with respect to the SiC substrate diameter r (50.8 mm), 0.4*r* (20.32 mm) or more. Herein, in Embodiment 2, the conditions in Embodiment 1 were modified to carry out the heteroepitaxial growth. Dislocation density in the AlN crystal at the AlN crystal thickness *t* of 1 mm was 6.0 × 10⁶ (/cm²).

Subsequently, the AlN crystal heteroepitaxially grown onto the SiC substrate was cut parallel to the SiC substrate surface in respective locations at a distance 200 µm from the SiC substrate and at a distance 0.5 mm from that location, in the direction opposite from that toward where the SiC substrate lay. Then the surface thereof was polished to a specular finish and etched, to fabricate an AlN crystal substrate (a first AlN crystal substrate A of Embodiment 2) in the form of a disk. Herein, the first AlN crystal substrate A of Embodiment 2 had diameter of 2 inches (50.8 mm) and thickness of 0.5 mm.

In the first AlN crystal substrate A of Embodiment 2, the full-width at half maximum of an X-ray rocking curve for its (0002) face and the dislocation density were evaluated in the same manner as, and under the same conditions as, in Embodiment 1. The results are set forth in Table II. As shown in Table II, in the first AlN crystal substrate A of Embodiment 2, the full-width at half maximum of an X-ray rocking curve for its (0002) face was 830 arcsec, and the dislocation density was 6 × 10⁶/cm².

Furthermore, in addition to the above first AlN crystal substrate A of Embodiment 2, the AlN crystal was cut parallel to the SiC substrate surface in each of locations at distances 200 µm + 2 mm, 200 µm + 4 mm, 200 µm + 10 mm, and 200 µm + 20 mm from the SiC substrate, and in locations at a distance of 0.5 mm from each of these locations in the direction opposite from that toward where the SiC substrate lay, to fabricate a first AlN crystal substrate B (cutting point: 200 µm + 2 mm), a first AlN crystal substrate *C*(cutting point: 200 µm + 4 mm), a first AlN crystal substrate D (cutting point: 200 µm + 10 mm), and a first AlN crystal substrate E(cutting point: 200 µm + 20 mm) of Embodiment 2.

Also in the first AlN crystal substrates B to E of Embodiment 2, the full-width at half maximum of an X-ray rocking curve for their (0002) faces and the dislocation density were evaluated in the same manner as, and under the same conditions as, in the above first AlN crystal substrate A of embodiment 2. The results are set forth in Table II.

As is clear from the results of evaluating the first AlN crystal substrates A to E of Embodiment 2, set forth in Table II, in the AlN crystal grown in Embodiment 2, letting the distance from the SiC substrate in the AlN crystal growing direction be t (mm) and the dislocation density in the AlN crystal when *t =* 1 be a (/cm²), then the dislocation density *E* in the AlN crystal lay in a region above the region between the function expressed by the formula of *E* = *a* × *t*^{-0.1} and the function expressed by the formula of *E*= *a* × *t*⁻³ for *t* ≥ 1, and the dislocation density in the AlN crystal was prone to increase with increasing AlN crystal thickness.

Furthermore, in the same manner as, and under the same conditions as, in Embodiment 1, an AlN crystal was homoepitaxially grown by sublimation onto the first AlN crystal substrate A of Embodiment 2. And, after the AlN crystal homoepitaxial growth, the AlN crystal was cooled down to room temperature (of 25°C).

The AlN crystal formed in the above manner was sliced in the same manner as, and under the same conditions as, in Embodiment 1, and the surface thereof was polished to a specular finish and etched, to produce an AlN crystal substrate (a second AlN crystal substrate A of Embodiment 2) having diameter of 2 inches and thickness of 0.5 mm in the form of a disk.

In the second AlN crystal substrate A of Embodiment 2, the full-width at half maximum of an X-ray rocking curve for its (0002) face and the dislocation density were characterized in the same manner as, and under the same conditions as, in Embodiment 1. The results are set forth in Table II. As shown in Table II, in the second AlN crystal substrate A of Embodiment 2, the full-width at half maximum of an X-ray rocking curve for its (0002) face was 600 arcsec, and the dislocation density was 5.8 × 10⁶/cm².

Also onto the above second crystal substrates B to Eof Embodiment 2, AlN crystals were each grown in the same manner as, and under the same conditions as, in the first AlN crystal substrate A of Embodiment 2, and second AlN crystal substrates B to E of Embodiment 2 were fabricated respectively from the grown AlN crystals, in the same manner as in the second AlN crystal substrate A of Embodiment 2.

Subsequently, also for the second AlN crystal substrates B to E of Embodiment 2, the full-width at half maximum of an X-ray rocking curve for their (0002) faces and the dislocation density were characterized in the same manner as, and under the same conditions as, in the second AlN crystal substrate A of Embodiment 2. The results are set forth in Table II.

**Table II**

| 1^{st} AlN crystal substrate cutting position | Location 200 µm away from SiC substrate | Location 200 µm + 2 mm away from SiC substrate | Location 200 µm + 4 mm away from SiC substrate | Location 200 µm + 10 mm away from SiC substrate | Location 200 µm + 20 mm away from SiC substrate |
|---|---|---|---|---|---|
| FWHM of X-ray rocking curve for 1^{st} AlN crystal substrate (arcsec) | 830 | 900 | 880 | 840 | 800 |
| Disloc. dens. of 1^{st} AlN crystal substrate (/cm²) | 6 × 10⁶ | 6.3 × 10⁶ | 6.2 × 10⁶ | 6.2 × 10⁶ | 6.0 × 10⁶ |
| FWHM of X-ray rocking curve for 2^{nd} AlN crystal substrate (arcsec) | 600 | 800 | 740 | 680 | 640 |
| Disloc. dens. of 2^{nd} AlN crystal substrate (/cm²) | 5.8 × 10⁶ | 6 × 10⁶ | 6.1 × 10⁶ | 5.8 × 10⁶ | 5.6 × 10⁶ |
| Characterized substrates | 1^{st} AlN crystal substrate *A* 2^{nd} AlN crystal substrate A | 1^{st} AlN crystal substrate B 2^{nd} AlN crystal substrate B | 1^{st} AlN crystal substrate C 2^{nd} AlN crystal substrate C | 1^{st} AlN crystal substrate D 2^{nd} AlN crystal substrate D | 1^{st} AlN crystal substrate *E* 2^{nd} AlN crystal substrate *E* |

As shown in Table II, the second AlN crystal substrates A to E of Embodiment 2 each exhibited a more favorable full-width at half maximum of an X-ray rocking curve for their (0002) faces and dislocation density, and were further improved in crystallinity, compared with the first AlN crystal substrates A to E of Embodiment 2, that served as a base of each of the second AlN crystal substrates *A* to *E.* The second AlN crystal substrates *A* to *E* of Embodiment 2 each, however, did not have more preferable full-width at half maximum of an X-ray rocking curve for their (0002) faces and dislocation density than the second AlN crystal substrates A to E of Embodiment 1.

### Embodiment 3

First, in the same manner as in Embodiment 1, onto a SiC substrate, an AlN crystal was heteroepitaxially grown by sublimation to a thickness of, with respect to the SiC substrate diameter r (50.8 mm), 0.4*r* (20.32 mm) or more. Herein, in Embodiment 3, the heteroepitaxial growth was carried out modifying the conditions from Embodiment 1. The dislocation density in the AlN crystal at an AlN crystal thickness t of 1 mm was 5.0 × 10⁶ (/cm²).

Subsequently, the AlN crystal heteroepitaxially grown onto the SiC substrate was cut parallel to the SiC substrate surface in respective locations at a distance 200 µm from the SiC substrate and at a distance 0.5 mm from that location, in the direction opposite from that toward where the SiC substrate lay. Then, the surface of the crystal cut off was polished to a specular finish, and etched, to fabricate an AlN crystal substrate (a first AlN crystal substrate A of Embodiment 3) in the form of a disk. Herein, the first AlN crystal substrate A of Embodiment 3 had diameter of 2 inches (50.8 mm) and thickness of 0.5 mm.

In the first AlN crystal substrate A of Embodiment 3, the full-width at half maximum of an X-ray rocking curve for its (0002) face and the dislocation density were evaluated in the same manner as, and under the same conditions as, in Embodiment 1. The results are set forth in Table III. As shown in Table III, in the first AlN crystal substrate A of Embodiment 3, the full-width at half maximum of an X-ray rocking curve for its (0002) face was 400 arcsec, and the dislocation density was 1.5 × 10⁷/cm².

Furthermore, in addition to the above first AlN crystal substrate A of Embodiment 3, the AlN crystal was cut parallel to the SiC substrate surface in each of locations at distances 200 µm + 2 mm, 200 µm + 4 mm, 200 µm + 10 mm, and 200 µm + 20 mm from the SiC substrate, and in locations at a distance of 0.5 mm from each of these locations in the direction opposite from that toward where the SiC substrate lay, to fabricate a first AlN crystal substrate B (cutting point: 200 µm + 2 mm), first AlN crystal substrate C (cutting point: 200 µm + 4 mm), a first AlN crystal substrate D (cutting point: 200 µm + 10 mm), and a first AlN crystal substrate E (cutting point: 200 µm + 20 mm) of Embodiment 3.

Also in the first AlN crystal substrates B to E of Embodiment 3, the full-width at half maximum of an X-ray rocking curve for their (0002) faces and the dislocation density were characterized in the same manner as, and under the same conditions as, in the above first AlN crystal substrate A of embodiment 3. The results are set forth in Table III.

As is clear from the results of evaluating the first AlN crystal substrates A to E of Embodiment 3, set forth in Table III, in the AlN crystal grown in Embodiment 3, letting the distance from the SiC substrate in the AlN crystal growth direction be *t*(mm) and the dislocation density in the AlN crystal when *t =* 1 be a (/cm²), then the dislocation density *E* of the AlN crystal lay in a region beneath the region between the function expressed by the formula of E= a x *t*^{-0.1} and the function expressed by the formula of *E = a* × *t*⁻³ for *t* ≥ 1, and the dislocation density in the AlN crystal abruptly decreased with increasing AlN crystal thickness. Additionally, in Embodiment 3, the AlN crystal grown onto the SiC substrate was confirmed to have severe warpage.

Furthermore, in the same manner as, and under the same conditions as, in Embodiment 1, an AlN crystal was homoepitaxially grown by sublimation onto the first AlN crystal substrate A of Embodiment 3. And, after the AlN crystal homoepitaxial growth, the AlN crystal was cooled down to room temperature (of 25°C).

The AlN crystal formed in the above manner was sliced in the same manner as, and under the same conditions as, in Embodiment 1, and the surface thereof was polished to a specular finish and etched, to produce an AlN crystal substrate (a second AlN crystal substrate A of Embodiment 3) having diameter of 2 inches and thickness of 0.5 mm in the form of a disk.

In the second AlN crystal substrate A of Embodiment 3, the full-width at half maximum of an X-ray rocking curve for its (0002) face and the dislocation density were characterized in the same manner as, and under the same conditions as, in Embodiment 1. The results are set forth in Table III. As shown in Table III, in the second AlN crystal substrate A of Embodiment 3, the full-width at half maximum of an X-ray rocking curve for its (0002) face was 550 arcsec, and the dislocation density was 6 × 10³/cm².

Furthermore, in the same manner as, and under the same conditions as, in the first AlN crystal substrate A of Embodiment 3, AlN crystals were each grown onto the above second AlN crystal substrates B to E of Embodiment 3, and second AlN crystal substrates B to E of Embodiment 3 were fabricated respectively from the grown AlN crystals, in the same manner as in the second AlN crystal substrate A of Embodiment 3.

Subsequently, also in the second AlN crystal substrates B to E of Embodiment 3, the full-width at half maximum of an X-ray rocking curve for their (0002) faces and the dislocation density were evaluated in the same manner as, and under the same conditions as, in the second AlN crystal substrate A of Embodiment 3. The results are set forth in Table III.

**Table III**

| 1^{st} AlN crystal substrate cutting position | Location 200 µm away from SiC substrate | Location 200 µm + 2 mm away from SiC substrate | Location 200 µm + 4 mm away from SiC substrate | Location 200 µm + 10 mm away from SiC substrate | Location 200 µm + 20 mm away from SiC substrate |
|---|---|---|---|---|---|
| FWHM of X-ray rocking curve for 1^{st} AlN crystal substrate (arcsec) | 400 | 520 | 550 | 650 | 710 |
| Disloc. dens. of 1^{st} AlN crystal substrate (/cm²) | 1.5 × 10⁷ | 4 × 10⁵ | 5.8 × 10⁴ | 2 × 10³ | 5.3 × 10² |
| FWHM of X-ray rocking curve for 2^{nd} AlN crystal substrate (arcsec) | 550 | 560 | 555 | 665 | 725 |
| Disloc. dens. of 2^{nd} AlN crystal substrate (/cm²) | 6 × 10³ | 3.5 × 10⁵ | 5.1 × 10⁴ | 1.8 × 10³ | 4.9 × 10² |
| Characterized substrates | 1^{st} AlN crystal substrate *A* 2^{nd} AlN crystal substrate *A* | 1^{st} AlN crystal substrate *B* 2^{nd} AlN crystal substrate *B* | 1^{st} AlN crystal substrate C 2^{nd} AlN crystal substrate *C* | 1^{st} AlN crystal substrate D 2^{nd} AlN crystal substrate *D* | 1^{st} AlN crystal substrate *E* 2^{nd} AlN crystal substrate *E* |

As shown in Table III, the second AlN crystal substrates A to E of Embodiment 3 tended to be lower in dislocation density, but were prone to have poor full-width at half maximums of the X-ray rocking curves for their (0002) faces, compared with the second AlN crystal substrates *A* to *E* of Embodiment 1.

### Comparative Example 1

In the same manner as, and under the same conditions as, in Embodiment 1, onto a SiC substrate, an 19 mm-thick AlN crystal-that is, with respect to the SiC substrate diameter r (50.8 mm), the AlN crystal thickness was less than 0.4*r* (20.32 mm)-was heteroepitaxially grown by sublimation. After the growth, when exfoliation of the SiC substrate was attempted, the AlN crystal broke due to cracking.

The presently disclosed embodiments should in all respects be considered to be illustrative and not limiting. The scope of the present invention is set forth not by the foregoing description but by the scope of the patent claims, and is intended to include meanings equivalent to the scope of the patent claims and all modifications within the scope.

### Industrial Applicability

The present invention affords AlN crystal substrate manufacturing methods, whereby large-scale, high-quality AlN crystal substrates can be manufactured, AlN crystal growth methods, whereby bulk, superior-crystallinity AlN crystals can be grown, and AlN crystal substrates composed of the AlN crystals grown by the growth methods.

## Claims

1. An AlN crystal substrate manufacturing method including:
a step of growing an AlN crystal by sublimation onto a heterogeneous substrate to a thickness of, with respect to the heterogeneous-substrate diameter *r*, 0.4*r* or more; and
a step of forming an AlN crystal substrate from a region of the AlN crystal not less than 200 µm away from the heterogeneous substrate.

2. The AlN crystal substrate manufacturing method set forth in claim 1, **characterized in that** the dislocation density of the AlN crystal monotonically decreases with increasing distance from the heterogeneous substrate in the direction in which the AlN crystal grows.

3. The AlN crystal substrate manufacturing method set forth in claim 2, **characterized in that,** letting distance from the heterogeneous substrate in the AlN crystal growing direction be t (mm) and dislocation density of the AlN crystal when *t =* 1 be a (/cm²), the dislocation density E of the AlN crystal lies in a region between the function expressed by the formula of *E = a* × *t*^{-0.1} and the function expressed by the formula of *E*= *a* × *t*⁻³, for *t* ≥ 1.

4. An AlN crystal growth method **characterized by** growing AlN crystal by sublimation onto an AlN crystal substrate manufactured by the AlN crystal substrate manufacturing method set forth in any of claims 1 through 3.

5. The AlN crystal growth method set forth in claim 4, **characterized in that** the AlN crystal substrate has a diameter of 2 inches or more.

6. The AlN crystal growth method set forth in claim 4 or 5, **characterized in that** the temperature of a raw material when the AlN crystal is grown onto the AlN crystal substrate is higher than the temperature of the raw material when AlN crystal is grown onto the heterogeneous substrate.

7. An AlN crystal substrate composed of AlN crystal grown by the AlN crystal growth method set forth in any of claims 4 through 6.
